# EUROPEAN PATENT APPLICATION

(11) **EP 1 852 877 A1**
(43) Date of publication of application: **07.11.2007**
(21) Application number: 06712398.4
(22) Date of filing: 26.01.2006
(51) Int. Cl.: H01B 12/06, H01B 13/00, H01F 6/06

(54) **SUPERCONDUCTING THIN FILM MATERIAL, SUPERCONDUCTING WIRE ROD AND METHODS FOR MANUFACTURING SUCH SUPERCONDUCTING THIN FILM MATERIAL AND SUPERCONDUCTING WIRE ROD**

(30) Priority: 03.02.2005 JP 2005027681
(71) Applicant: Sumitomo Electric Industries, Ltd., Osaka-shi, Osaka 541-0041 (JP); International Superconductivity Technology Center, The Juridical Foundation, Tokyo 105-0004 (JP)
(72) Inventor: OHMATSU, Kazuya Osaka Works of Sumitomo El.Ind.Ltd, Osaka-shi, Osaka 554-8511 (JP); HAHAKURA, Shuji Osaka Works of Sumitomo El.Ind.Ltd, Osaka-shi, Osaka 554-8511 (JP)
(74) Representative: Desormiere, Pierre-Louis
(86) International application number: PCT/JP2006/301216
(87) International publication number: WO 2006/082747

(57) **Abstract**

A superconducting thin film material (1) is provided, including a first superconducting thin film (1a) having a surface subjected to smoothing and a second superconducting thin film (1b) formed on the surface of the first superconducting thin film (1a) subjected to the smoothing. Further, a superconducting wire (10) is provided, including a substrate (2), an intermediate layer (3) formed on the substrate (2), and a superconducting layer (4) formed on the intermediate layer (3), wherein the superconducting layer (4) is made of the superconducting thin film material (1) described above. Furthermore, a method of manufacturing the superconducting thin film material (1) and a method of manufacturing the superconducting wire (10) are provided.

## Description

### Technical Field

The present invention relates to a superconducting thin film material, a superconducting wire, and a method of manufacturing the same. In particular, the present invention relates to a superconducting thin film material, a superconducting wire, and a method of manufacturing the same capable of enhancing the amount of an increase in critical current associated with increased film thickness.

### Background Art

Since the discovery of high-temperature superconductors, significant effort has been devoted toward the development of superconducting wires in research institutes around the world, aiming for their application to electric power equipment such as a cable, a fault current limiter, or a magnet.

Examples of conventional known superconducting wires include a superconducting wire in which a superconducting thin film is formed directly on a substrate (see for example Japanese Patent Laying-Open No. 06-031604 (Patent Document 1), Japanese Patent Laying-Open No. 06-068727 (Patent Document 2), and Japanese Patent Laying-Open No. 06-068728 (Patent Document 3)), and a superconducting wire in which a superconducting thin film is formed on a substrate with an intermediate layer interposed therebetween (see for example Fujino, et al., "Development of High-Temperature Superconducting Thin Film Tape Using the ISD Method", SEI Technical Review, September 1999, vol. 155, pp.131-135 (Non-Patent Document 1)).

Further, in the manufacture of such a superconducting wire, it has been proposed to polish the surface of a substrate beforehand and then form a superconducting thin film on the surface of the substrate in order to obtain high critical current (see for example Patent Documents 1-3)
Patent Document 1: Japanese Patent Laying-Open No. 06-031604
Patent Document 2: Japanese Patent Laying-Open No. 06-068727
Patent Document 3: Japanese Patent Laying-Open No. 06-068728
Non-Patent Document 1: Fujino, et al., "Development of High-Temperature Superconducting Thin Film Tape Using the ISD Method", SEI Technical Review, September 1999, vol. 155, pp. 131-135

### Disclosure of the Invention

### Problems to be Solved by the Invention

In order to obtain high critical current in a superconducting thin film, surface smoothness of the superconducting thin film is a critically important factor. However, the surface smoothness of the superconducting thin film deteriorates with increasing thickness of the superconducting thin film.

As a result, even in a case where a thicker superconducting thin film is fabricated to obtain high critical current, an increase in critical current associated with increased film thickness gradually slows down, failing to obtain high critical current.

Consequently, one object of the present invention is to provide a superconducting thin film material, a superconducting wire, and a method of manufacturing the same capable of enhancing the amount of an increase in critical current associated with increased film thickness.

### Means for Solving the Problems

The present invention is a superconducting thin film material, including a first superconducting thin film having a surface subjected to smoothing, and a second superconducting thin film formed on the surface of the first superconducting thin film subjected to the smoothing.

In the superconducting thin film material of the present invention, the smoothing can be performed by at least one of mechanical polishing and chemical polishing.

Further, the present invention is a superconducting wire, including a substrate, an intermediate layer formed on the substrate, and a superconducting layer formed on the intermediate layer, wherein the superconducting layer is made of the superconducting thin film material described above.

In the superconducting wire of the present invention, the substrate can be made of an elemental metal or an alloy. Further, in the superconducting wire of the present invention, the intermediate layer can be made of an oxide having a rock-salt-type, fluorite type, perovskite-type, or pyrochlore-type crystal structure.

Furthermore, in the superconducting wire of the present invention, the superconducting layer can be made of an RE-123 superconductor.

Further, the present invention is a method of manufacturing a superconducting thin film material, including the steps of: performing smoothing on a surface of a first superconducting thin film; and forming a second superconducting thin film on the surface of the first superconducting thin film subjected to the smoothing.

In the method of manufacturing the superconducting thin film material of the present invention, the smoothing can be performed by at least one of mechanical polishing and chemical polishing.

Further, the present invention is a method of manufacturing the superconducting wire according to any of those described above, including the steps of forming the intermediate layer on the substrate; forming a first superconducting thin film on the intermediate layer; performing smoothing on a surface of the first superconducting thin film; and forming a second superconducting thin film on the surface of the first superconducting thin film subjected to the smoothing.

### Effects of the Invention

According to the present invention, a superconducting thin film material, a superconducting wire, and a method of manufacturing the same capable of enhancing the amount of an increase in critical current associated with increased film thickness can be provided.

### Brief Description of the Drawings

Fig. 1 is a schematic cross sectional view showing a preferred example of a superconducting thin film material of the present invention.
Fig. 2 is a flow chart illustrating a preferred example of a method of manufacturing the superconducting thin film material of the present invention.
Fig. 3 is a schematic cross sectional view showing a portion of a preferred example of a superconducting wire of the present invention.
Fig. 4 is a flow chart illustrating a preferred example of a method of manufacturing the superconducting wire of the present invention.
Fig. 5 is a schematic cross sectional view showing an apparatus used in an example of the present invention.

### Description of the Reference Signs

1 superconducting thin film material, 1a first superconducting thin film, 1b second superconducting thin film, 2 substrate, 3 intermediate layer, 4 superconducting layer, 5 target, 6 KrF excimer laser beam, 7 plasma, 10 superconducting wire.

### Best Modes for Carrying Out the Invention

The present invention is a superconducting thin film material, including a first superconducting thin film having a surface subjected to smoothing, and a second superconducting thin film formed on the surface of the first superconducting thin film subjected to the smoothing.

Conventionally, a thick superconducting thin film material has been formed at one time by extending the period of time for formation using a method such as pulsed laser deposition. However, since superconducting thin films are formed in an accumulative manner on a surface having poor smoothness, there has been a tendency that surface smoothness deteriorates with increasing film thickness of the superconducting thin film material.

Therefore, in the present invention, in order to form a thicker superconducting thin film material, smoothing is performed on a surface of a first superconducting thin film during the formation of the superconducting thin film material, and then a second superconducting thin film is continuously formed on the smoothed surface of the first superconducting thin film, instead of forming the entire superconducting thin film material at one time. Thereby, in the present invention, a superconducting thin film material excellent in surface smoothness can be obtained, a slowdown in the amount of an increase in critical current associated with increased film thickness can be prevented, and thus high critical current can be achieved. It is to be noted that, in the present invention, smoothing may further be performed on a surface of the second superconducting thin film and then an additional third superconducting thin film may be formed thereon. Such smoothing on a surface of a superconducting thin film and subsequent formation of an additional superconducting thin film on the smoothed surface of the superconducting thin film may be repeated.

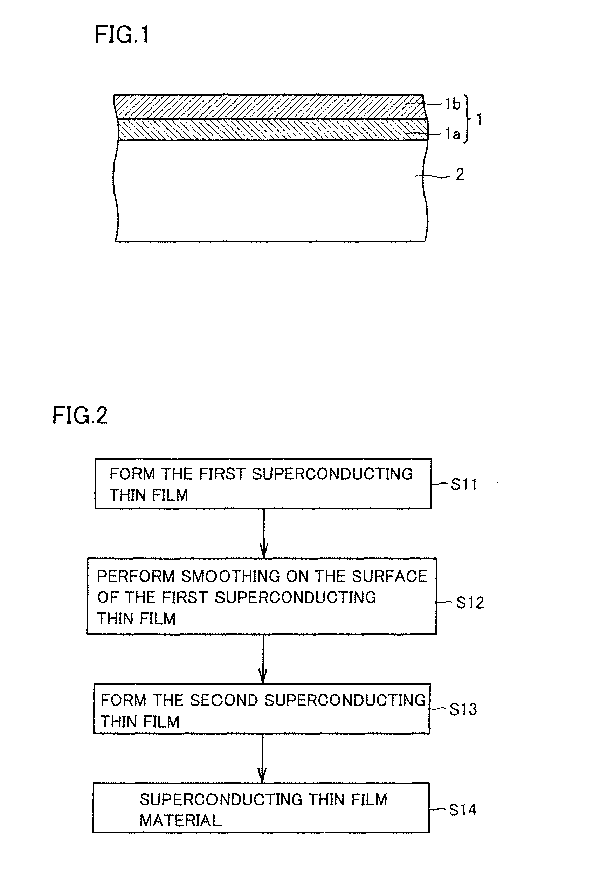

Fig. 1 is a schematic cross sectional view showing a preferred example of a superconducting thin film material of the present invention. A superconducting thin film material 1 of the present invention includes a first superconducting thin film 1a formed on a substrate 2, and a second superconducting thin film 1b. A material constituting superconducting thin film material 1 of the present invention (a material constituting the first superconducting thin film 1a and the second superconducting thin film 1b) is not particularly limited as long as it has a superconducting property, and for example an RE-123 superconductor may be used. It is to be noted that an RE-123 superconductor is a superconductor expressed in the formula REBa₂Cu₃Oₓ, where x is 6-7 and RE represents a rare earth element such as holmium, gadolinium or samarium, or yttrium. Further, as a material constituting substrate 2, an elemental metal or an alloy, such as nickel or a nickel alloy, can be used.

Fig. 2 is a flow chart illustrating a preferred example of a method of manufacturing the superconducting thin film material of the present invention. Firstly, as shown in S 11, the first superconducting thin film is formed on a surface of the substrate. The first superconducting thin film can be formed by a method such as pulsed laser deposition.

Next, as shown in S 12, a surface of the first superconducting thin film formed on the surface of the substrate is subjected to smoothing. Smoothing can be performed by at least one of mechanical polishing and chemical polishing, such as CMP (Chemical Mechanical Polishing), wet etching, or mechanical polishing. Further, the smoothing is performed preferably until the surface of the first superconducting thin film has a surface roughness Ra (JIS B0601) of not more than 10 nm, and more preferably until it has a surface roughness Ra of not more than 6 nm.

Thereafter, as shown in S 13, the second superconducting thin film is formed on the smoothed surface of the first superconducting thin film. Similar to the first superconducting thin film, the second superconducting thin film is formed by a method such as pulsed laser deposition.

Then, as shown in S 14, the superconducting thin film material of the present invention is manufactured. It is to be noted that, in the manufacturing method described above, a surface of the second superconducting thin film may further be smoothed, and then an additional third superconducting thin film may be formed on the smoothed surface of the second superconducting thin film. Such smoothing on a surface of a superconducting thin film and subsequent formation of an additional superconducting thin film on the smoothed surface of the superconducting thin film may be repeated.

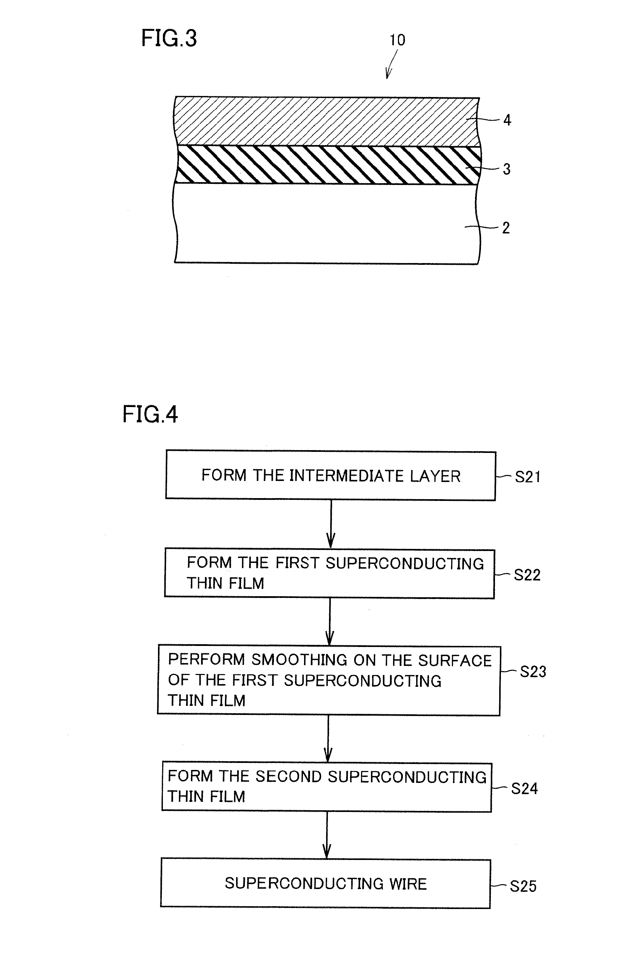

Fig. 3 is a schematic cross sectional view showing a portion of a preferred example of a superconducting wire of the present invention. A superconducting wire 10 of the present invention includes substrate 2, an intermediate layer 3 formed on substrate 2, and a superconducting layer 4 formed on intermediate layer 3.

Superconducting wire 10 of the present invention is characterized by using the superconducting thin film material of the present invention described above as superconducting layer 4. Specifically, superconducting layer 4 has a smooth surface even when it has an increased film thickness, and thus high critical current can also be achieved in superconducting wire 10 of the present invention without causing a slowdown in the amount of an increase in critical current associated with the increased film thickness of superconducting layer 4.

Further, as a material constituting substrate 2, an elemental metal or an alloy, such as nickel or a nickel alloy, can be used as in the above description. As a material constituting intermediate layer 3, for example, an oxide having one of rock-salt-type, fluorite-type, perovskite-type, and pyrochlore-type crystal structures can be used. Examples of the oxide having the crystal structure described above include an oxide of a rare earth element such as YSZ (yttria-stabilized zirconia) or CeO₂ (cerium dioxide), BZO (BaZrO₃), STO (SrTiO₃), and Al₂O₃. Further, intermediate layer 3 may be formed of not only a single layer but also a plurality of layers made of different materials. It is to be noted that, in the superconducting wire of the present invention, a coating layer made for example of silver for coating the superconducting layer may be formed to protect the superconducting layer.

Fig. 4 is a flow chart illustrating a preferred example of a method of manufacturing the superconducting wire of the present invention. Firstly, as shown in S21, the intermediate layer is formed on a surface of the substrate. The intermediate layer can be formed by a method such as pulsed laser deposition.

Next, as shown in S22, the first superconducting thin film is formed on a surface of the intermediate layer. The first superconducting thin film can be formed by a method such as pulsed laser deposition.

Thereafter, as shown in S23, smoothing is performed on a surface of the first superconducting thin film formed on the surface of the intermediate layer. Smoothing can be performed by at least one of mechanical polishing and chemical polishing, such as CMP (Chemical Mechanical Polishing), wet etching, or mechanical polishing described above. Again, the smoothing is performed preferably until the surface of the first superconducting thin film has a surface roughness Ra (JIS B0601) of not more than 10 nm, and more preferably until it has a surface roughness Ra of not more than 6 nm.

Next, as shown in S24, the second superconducting thin film is formed on the smoothed surface of the first superconducting thin film. Similar to the first superconducting thin film, the second superconducting thin film can be formed by a method such as pulsed laser deposition.

Then, as shown in S25, the superconducting thin film material is formed on the surface of the intermediate layer, and thus the superconducting wire of the present invention is manufactured. It is to be noted that, in the manufacturing method described above, smoothing may further be performed on a surface of the second superconducting thin film, and then an additional third superconducting thin film may be formed thereon. Such smoothing on a surface of a superconducting thin film and subsequent formation of an additional superconducting thin film on the smoothed surface of the superconducting thin film may be repeated.

### Example

### First Example

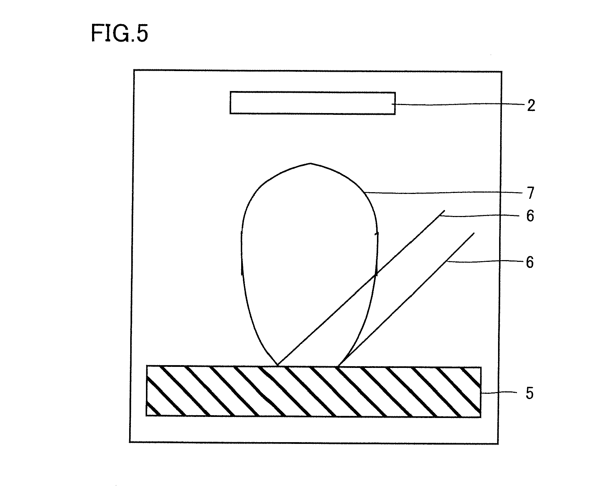

Firstly, substrate 2 made of a nickel alloy was placed within an apparatus shown in the schematic cross sectional view in Fig. 5, and a target 5 made of yttria-stabilized zirconia was also placed below substrate 2. On this occasion, substrate 2 and target 5 were placed such that a surface of substrate 2 and a surface of target 5 were parallel and faced each other. Then, the distance between the surface of substrate 2 and the surface of target 5 was set to 50 mm. The yttria-stabilized zirconia was made by adding yttria (Y₂O₃) to zirconium oxide (ZrO₂), in an amount of 8 percent by mass of the zirconium oxide.

Next, the apparatus was evacuated. Thereafter, mixed gas containing 90 percent by volume of argon (Ar) and 10 percent by volume of oxygen (O₂) was introduced into the apparatus, and the pressure inside the apparatus was set at 1×10⁷ torr.

Then, substrate 2 was heated to have a temperature of 700°C, and thereafter the surface of target 5 was irradiated with a KrF excimer laser beam 6 having a wavelength of 248 nm and an energy illuminance of 3.5 J/cm², at a cyclic frequency of 40 Hz in a pulsed manner. Thereby, plasma 7 of target 5 was generated to form an intermediate layer made of the yttria-stabilized zirconia and having a thickness of 1 µm on the surface of substrate 2.

Next, target 5 was changed to another target 5 made of HoBa₂Cu₃Oₓ (an RE-123 superconductor), and the apparatus was evacuated again. Thereafter, gas containing 100 percent by volume of oxygen was introduced into the apparatus, and the pressure inside the apparatus was set at 2×10⁸ torr.

Then, after substrate 2 was set to have a temperature of 650°C, the surface of target 5 was irradiated with KrF excimer laser beam 6 having a wavelength of 248 nm and an energy illuminance of 3.5 J/cm², at a cyclic frequency of 80 Hz in a pulsed manner. Thereby, plasma 7 of target 5 was generated to form a first superconducting thin film made of the RE-123 superconductor and having a film thickness of 1 µm on the surface of the intermediate layer.

A superconducting wire obtained in this manner was referred to as sample A, and a surface roughness Ra of the first superconducting thin film of sample A was measured using an Atomic Force Microscope (AFM), and a critical current value Ic thereof was measured by the four-terminal method. Table 1 shows the results. As shown in Table 1, the first superconducting thin film of sample A had a surface roughness Ra of 55 nm and a critical current value Ic of 110 A/cm-width.

The surface of the first superconducting thin film of sample A was subjected to smoothing, with its thickness polished and removed by 0.1 µm using CMP (that is, the first superconducting thin film after being polished and removed had a film thickness of 0.9 µm). A surface roughness Ra of the first superconducting thin film subjected to the smoothing was measured using the AFM, and a surface roughness Ra of 6 nm was obtained.

Thereafter, sample A subjected to the smoothing described above was placed at a position of substrate 2 in the apparatus shown in Fig. 5, and a second superconducting thin film made of the RE-123 superconductor and having a film thickness of 1 µm was formed on the smoothed surface of the first superconducting thin film of sample A under the same conditions as those for forming the first superconducting thin film in sample A described above. Thereby, a superconducting layer including the first superconducting thin film and the second superconducting thin film was formed on the intermediate layer (the superconducting layer had a thickness of 1.9 µm).

A superconducting wire obtained in this manner was referred to as sample B, and a surface roughness Ra of the superconducting layer of sample B was measured using the AFM, and a critical current value Ic thereof was measured by the four-terminal method, as in sample A. Table 1 shows the results. As shown in Table 1, sample B had a surface roughness Ra of 6 nm and a critical current value Ic of 200 A/cm-width.

### First Comparative Example

A substrate made of a nickel alloy having an intermediate layer made of yttria-stabilized zirconia and an intermediate layer made of cerium dioxide formed thereon in this order was prepared. Thereafter, a superconducting thin film made of an RE-123 superconductor and having a film thickness of 2 µm was formed on a surface of the intermediate layer made of cerium dioxide.

A superconducting wire obtained in this manner was referred to as sample C, and a surface roughness Ra of the superconducting thin film of sample C was measured using the AFM, and a critical current value Ic thereof was measured by the four-terminal method, as in samples A and B. Table 1 shows the results. As shown in Table 1, sample C had a surface roughness Ra of 80 nm and a critical current value Ic of 140 A/cm-width.

**[Table 1]**

| Sample | A | B | C |
|---|---|---|---|
| The surface of the superconducting thin film is subjected to smoothing | No | Yes | No |
| Film thickness of the superconducting thin film (µm) | 1.0 | 1.9 | 2.0 |
| Surface roughness Ra (nm) | 55 | 6 | 80 |
| Critical current value Ic (A/cm-width) | 110 | 200 | 140 |

As shown in Table 1, when a comparison was made between sample A and sample C, both of which were not subjected to smoothing, sample C having a greater film thickness of the superconducting thin film had a greater critical current value Ic. However, it was confirmed that sample B, in which the surface of the first superconducting thin film was subjected to smoothing by CMP and then the second superconducting thin film was formed thereon, had a critical current value Ic greater than that of sample C even though it had almost the same film thickness as that of sample C. Consequently, it was confirmed that the amount of an increase in critical current associated with increased film thickness can be enhanced in the present invention.

It should be understood that the disclosed embodiment and example above are, in all respects, by way of illustration only and are not by way of limitation. The scope of the present invention is set forth by the claims rather than the above description and is intended to cover all the modifications within a spirit and scope equivalent to those of the claims.

### Industrial Applicability

The superconducting thin film material and the superconducting wire of the present invention are suitably applicable to electric power equipment such as a cable, a fault current limiter, or a magnet.

## Claims

1. A superconducting thin film material (1), comprising:
a first superconducting thin film (1a) having a surface subjected to smoothing; and
a second superconducting thin film (1b) formed on the surface of the first superconducting thin film (1a) subjected to said smoothing.

2. The superconducting thin film material (1) according to claim 1, wherein said smoothing is performed by at least one of mechanical polishing and chemical polishing.

3. A superconducting wire (10), comprising:
a substrate (2);
an intermediate layer (3) formed on said substrate (2); and
a superconducting layer (4) formed on said intermediate layer (3),
wherein said superconducting layer (4) is made of the superconducting thin film material (1) according to claim 1.

4. The superconducting wire (10) according to claim 3, wherein said substrate (2) is made of an elemental metal or an alloy.

5. The superconducting wire (10) according to claim 3, wherein said intermediate layer (3) is made of an oxide having a rock-salt-type, fluorite-type, perovskite-type, or pyrochlore-type crystal structure.

6. The superconducting wire (10) according to claim 3, wherein said superconducting layer (4) is made of an RE-123 superconductor.

7. A method of manufacturing a superconducting thin film material (1), comprising the steps of:
performing smoothing on a surface of a first superconducting thin film (1a); and
forming a second superconducting thin film (1b) on the surface of the first superconducting thin film (1a) subjected to said smoothing.

8. The method of manufacturing the superconducting thin film material (1) according to claim 7, wherein said smoothing is performed by at least one of mechanical polishing and chemical polishing.

9. A method of manufacturing the superconducting wire (10) according to claim 3, comprising the steps of
forming said intermediate layer (3) on said substrate (2);
forming a first superconducting thin film (1a) on said intermediate layer (3);
performing smoothing on a surface of the first superconducting thin film (1a); and
forming a second superconducting thin film (1b) on the surface of the first superconducting thin film (1a) subjected to said smoothing.
